# FASCICULE DE BREVET EUROPEEN

(11) **EP 2 920 846 B1**
(45) Date de publication et mention de la délivrance du brevet: **05.08.2020**
(21) Numéro de dépôt: 13789330.1
(22) Date de dépôt: 12.11.2013
(51) Int. Cl.: H01Q 17/00, H01P 1/22, H05K 9/00

(54) **DISPOSITIF ET PROCEDE D'ATTENUATION VARIABLE D'UN SIGNAL HYPERFREQUENCE RAYONNE**
VORRICHTUNG UND VERFAHREN ZUR VARIABLEN ABSCHWÄCHUNG EINES EMITTIERTEN MIKROWELLENSIGNALS
DEVICE AND METHOD FOR VARIABLY ATTENUATING AN EMITTED MICROWAVE SIGNAL

(30) Priorité: 14.11.2012 FR 1260839
(43) Date de publication de la demande: 23.09.2015
(73) Titulaire: Commissariat à l'Énergie Atomique et aux Énergies Alternatives, 75015 Paris (FR)
(72) Inventeur: PAUPERT, Alain, F-46120 Lacapelle Marival (FR)
(74) Mandataire: Brevalex
(86) Numéro de dépôt international: PCT/EP2013/073599
(87) Numéro de publication internationale: WO 2014/076070

(56) Documents cités:
- EP-A1- 2 328 232
- CN-A- 1 758 844
- GB-A- 761 366
- US-A1- 2005 017 819

## Description

### DOMAINE TECHNIQUE

L'invention concerne un dispositif et un procédé de mesure liés à un dispositif d'atténuation variable d'un signal hyperfréquence rayonné.

Le domaine de l'invention est le domaine électromagnétique hyperfréquence et plus particulièrement celui des atténuateurs pour la mesure de champs électromagnétiques micro-ondes dans la gamme 1GHz - 18 GHz, par exemple pour de fortes puissances allant de quelques kilowatts à des centaines de mégawatts en mode impulsionnel.

### ÉTAT DE LA TECHNIQUE ANTÉRIEURE

Dans le domaine de l'invention, on connait des atténuateurs à alcool à atténuation fixe. Comme décrit dans le document référencé [1] en fin de description, ces atténuateurs peuvent être constitués de deux plaques de plexiglas séparées par une cale sur le contour et remplis d'alcool. Chaque atténuateur à une atténuation déterminée par l'épaisseur d'alcool. La valeur d'atténuation varie en fonction de la fréquence. En combinant plusieurs atténuateurs, on obtient une variation d'atténuation.

Mais de tels atténuateurs présentent les inconvénients suivants. Il est difficile d'obtenir une valeur répétitive et progressive des valeurs d'atténuation en fonction des combinaisons utilisées. La valeur d'atténuation de la combinaison utilisée ne correspond pas forcément à la somme des valeurs d'atténuation de chaque atténuateur. Il est peu aisé de manier des écrans du fait de leur poids. Il est nécessaire de travailler dans un périmètre sécurisé (danger électromagnétique et rayonnements ionisants) pour modifier le nombre et la position des écrans.

Des dispositifs d'atténuation variable sont également connus, voir EP2328232 A1 et GB761366A.

L'invention a pour objet un dispositif et un procédé d'atténuation hyperfréquence pour de fortes puissances permettant de palier ces inconvénients.

### EXPOSÉ DE L'INVENTION

L'invention concerne un dispositif et un procédé de mesure d'un champ électromagnétique rayonné par une source micro-ondes de forte puissance, selon la revendication 1, le dit dispositif comprenant un dispositif d'atténuation variable d'un signal hyperfréquence rayonné, par exemple pour de fortes puissances allant de quelques kilowatts à des centaines de mégawatts en mode impulsionnel.

Les revendications dépendantes définissent des modes de réalisation plus spécifiques.

Le dispositif de l'invention présente les avantages suivants :
- une atténuation mieux maitrisée,
- pas d'intervention dans le périmètre sécurisé de la source,
- un pilotage à distance de la valeur d'atténuation.

Le dispositif de l'invention est utilisable pour un générateur micro-ondes de forte puissance.

### BRÈVE DESCRIPTION DES DESSINS

Les figures 1 et 2 illustrent schématiquement le dispositif de l'invention dans une vue de côté et dans une vue de face.
La figure 3 illustre un synoptique de mise en œuvre du dispositif de l'invention.

### EXPOSÉ DÉTAILLÉ DE MODES DE RÉALISATION PARTICULIERS

L'invention consiste à faire varier à distance un volume d'un liquide absorbant l'énergie électromagnétique rayonnée, par exemple de l'alcool, dans un cylindre étanche, par le déplacement d'un piston soumis à une pression. Le volume de ce liquide est contrôlé par un capteur de déplacement qui situe la position du piston dans le cylindre. Le remplissage et la vidange de ce liquide sont réalisés par une pompe. Le déplacement du piston est effectué par une commande pneumatique.

Les matériaux utilisés dans le dispositif de l'invention sont neutres d'un point de vue électromagnétique.

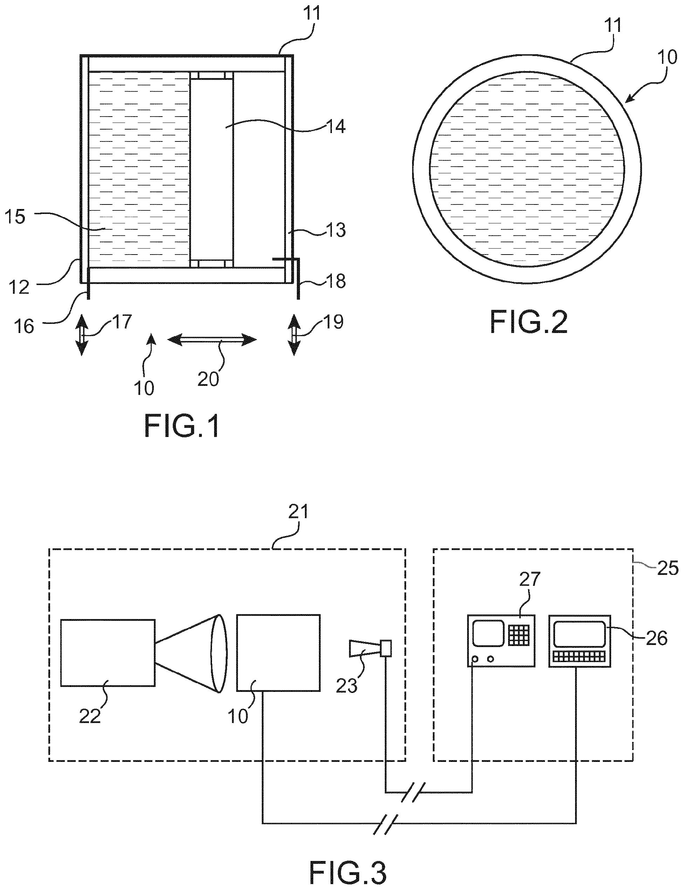

Comme illustré sur les figures 1 et 2, le dispositif de l'invention 10 comprend un cylindre formé d'une paroi cylindrique 11 fermée de part et d'autre par un premier et un second flasques dans lequel peut se déplacer un piston 14 délimitant avec le premier flasque un volume rempli d'alcool 15. La paroi cylindrique est percée à sa première extrémité, située du côté du premier flasque, d'un orifice 16 d'entrée/sortie d'alcool 17. Le second flasque 13 est percé d'un orifice 18 d'entrée/sortie d'air 19. Un capteur de déplacement permet de connaître le déplacement 20 du piston 14.

Les moyens de commandes du dispositif de l'invention comprennent :
- un boîtier d'interface de commande des électrovannes et des pompes à alcool,
- un boîtier d'interface pour la commande à distance.

La figure 3 illustre la mise en œuvre du dispositif de l'invention 10, avec :
- une cage de test 21 dans laquelle sont disposés :
   - une source micro-ondes de forte puissance 22,
   - le dispositif 10 décrit ci-dessus,
   - un capteur de mesure du champ électromagnétique 23.
- une cage de commande 25 dans laquelle sont disposés :
   - un organe de commande 26,
   - un organe de visualisation 27.

Grâce au dispositif de l'invention on fait donc varier un volume de liquide absorbant l'énergie électromagnétique, par exemple de l'alcool, dans un cylindre étanche placé devant une source micro-ondes de forte puissance. L'énergie électromagnétique rayonnée est absorbée par ce liquide et dissipée par échange thermique. L'atténuation du champ électromagnétique est plus ou moins importante suivant le volume de ce liquide placé devant la source.

Les caractéristiques du dispositif de l'invention sont les suivantes :
- puissances : de quelques kilowatts à des centaines de mégawatts en mode impulsionnel,
- atténuation : de 3 à 40 dB,
- plage de fréquences : 1 à 18 GHz,
- pas d'atténuation : 0,5 dB.

Dans un exemple de réalisation avantageux, le dispositif de l'invention présente les caractéristiques suivantes :
- diamètre extérieur : 530 mm,
- profondeur : 290 mm,
- diamètre du piston : 525 mm,
- déplacement utile du piston : 50 mm,
- volume maximum d'alcool : 11 litres,
- type d'alcool : Ethanol à 95%.

Le matériau utilisé pour les différents éléments constituant le cylindre étanche de volume variable du dispositif de l'invention sont du polyéthylène et/ou du polycarbone.

### Références

[1] « Modification du générateur de forte puissance sinus 50 » (DGA/DGE/CEG Marché n°9925028 ; Rapport final n°IS RF 99-079A, 11 avril 2000).

## Revendications

1. Dispositif de mesure d'un champ électromagnétique rayonné par une source micro-ondes de forte puissance (22), comprenant :
- une cage de test (21) dans laquelle sont disposés :
• la source micro-ondes (22) ;
• un capteur de mesure de champ électromagnétique (23) ; et
• un dispositif d'atténuation variable de signal hyperfréquence rayonné, qui comprend un organe étanche (11) contenant un liquide absorbant l'énergie électromagnétique, dans lequel un piston (14) est propre à se déplacer, et des moyens de commande du déplacement de ce piston situés à distance, dans lequel cet organe est un cylindre formé d'une paroi cylindrique (11) fermée de part et d'autre par un premier et un second flasques (12 et 13), et dans lequel le piston (14) délimite avec le premier flasque un volume variable rempli de ce liquide (15), le cylindre étant percé à une première extrémité, située du côté du premier flasque, d'un orifice (16) d'entrée/sortie de liquide (17), le second flasque (13) étant percé d'un orifice (18) d'entrée/sortie d'air (19), un capteur de déplacement (20) du piston (14) permettant de connaître le déplacement du piston dans le cylindre, le dispositif d'atténuation variable étant placé axialement par rapport à la source micro-ondes (22) et au capteur de mesure de champ électromagnétique (23), entre la source micro-ondes et le capteur de mesure de champ électromagnétique (23) ;
- une cage de commande (25) dans laquelle sont disposés :
• un organe de commande (26) ; et
• un organe de visualisation (27).

2. Dispositif selon la revendication 1, dans lequel ce liquide est de l'alcool.

3. Dispositif selon la revendication 2, dans lequel l'organe de commande (26) comprend :
- un boîtier d'interface de commande d'électrovannes et de pompes à alcool ; et
- un boîtier d'interface pour la commande à distance.

4. Dispositif selon la revendication 1 qui comprend des éléments en polyéthylène et/ou en polycarbone.

5. Dispositif selon l'une quelconque des revendications précédentes, pour de fortes puissances allant de quelques kilowatts à des centaines de mégawatts en mode impulsionnel.

6. Procédé de mesure d'un signal électromagnétique pour de fortes puissances allant de quelques kilowatts à des centaines de mégawatts en mode impulsionnel, utilisant un dispositif selon l'une quelconque des revendications 1 à 5 dans lequel on déplace le piston (14) d'une longueur désirée pour faire varier le volume variable rempli de liquide (15).

## Patentansprüche

1. Vorrichtung zur Messung eines elektromagnetischen Felds, das durch eine Hochleistungsmikrowellenquelle (22) ausgestrahlt wird, umfassend:
- einen Testkäfig (21), in dem angeordnet sind:
• die Mikrowellenquelle (22);
• ein Sensor zur Messung des elektromagnetischen Felds (23); und
• eine Vorrichtung zur variablen Abschwächung des ausgestrahlten Hyperfrequenzsignals, die ein dichtes Organ (11) umfasst, das eine Flüssigkeit enthält, die die elektromagnetische Energie absorbiert, in der ein Kolben (14) dazu ausgelegt ist, sich zu verlagern, sowie Mittel zur Steuerung der Verlagerung dieses Kolbens, die im Abstand angeordnet sind, wobei dieses Organ ein Zylinder ist, gebildet durch eine zylindrische Wand (11), die auf beiden Seiten durch einen ersten und einen zweiten Flansch (12 und 13) geschlossen ist, und wobei der Kolben (14) zusammen mit dem ersten Flansch ein variables Volumen begrenzt, das mit dieser Flüssigkeit (15) gefüllt ist, wobei der Zylinder an einem ersten Ende, das an der Seite des ersten Flanschs angeordnet ist, durch eine Öffnung (16) für den Eintritt/Austritt von Flüssigkeit (17) durchbohrt ist, wobei der zweite Flansch (13) durch eine Öffnung (18) für den Eintritt/Austritt von Luft (19) durchbohrt ist, wobei ein Verlagerungssensor (20) für den Kolben (14) es erlaubt, die Verlagerung des Kolbens in dem Zylinder zu erfassen, wobei die Vorrichtung zur variablen Abschwächung axial mit Bezug zu der Mikrowellenquelle (22) und zu dem Sensor zur Messung des elektromagnetischen Felds (23) zwischen der Mikrowellenquelle und dem Sensor zur Messung des elektromagnetischen Felds (23) platziert ist;
- einen Steuerkäfig (25), in dem angeordnet sind
• ein Steuerorgan (26); und
• ein Visualisierungsorgan (27).

2. Vorrichtung nach Anspruch 1, bei der diese Flüssigkeit Alkohol ist.

3. Vorrichtung nach Anspruch 2, bei der das Steuerorgan (26) umfasst:
- ein Schnittstellengehäuse zur Steuerung von Elektroventilen und von Alkoholpumpen: und
- ein Schnittstellengehäuse für die Steuerung auf Abstand.

4. Vorrichtung nach Anspruch 1, die Elemente aus Polyethylen und/oder aus Polycarbon umfasst.

5. Vorichtung nach einem der vorhergehenden Ansprüche, für hohe Leistungen, die von einigen Kilowatt bis zu einigen hundert Megawatt im Pulsmodus gehen.

6. Verfahren zur Messung eines elektromagnetischen Signals für hohe Leistungen, die von einigen Kilowatt bis zu mehreren hundert Megawatt im Pulsmodus gehen, unter Verwendung einer Vorrichtung nach einem der Ansprüche 1 bis 5, bei dem man den Kolben (14) um eine gewünschte Länge verlagert, um das variable Volumen variieren zu lassen, das mit Flüssigkeit (15) gefüllt ist.

## Claims

1. A device for measuring an electromagnetic field radiated from a high power microwave source (22), comprising:
- a testing cage (21), in which are provided:
• the microwave source (22);
• an electromagnetic field measuring sensor (23); and
• a variable attenuation device for variably attenuating a radiated microwave signal, which comprises a watertight member (11) filled with an electromagnetic energy absorbing liquid, in which a piston (14) can be displaced, and remote control means for controlling displacement of said piston, wherein said member is a cylinder formed by a cylinder wall (11) closed on either side by a first and a second flange (12 and 13), and wherein the piston (14) bounds with the first flange a variable volume filled with this liquid (15), the cylinder being pierced at a first end, located on the first flange side, with a liquid (17) inlet/outlet port (16), the second flange (13) being pierced with an air (19) inlet/outlet port (18), a displacement sensor (20) enabling the displacement (20) of the piston (14) within the cylinder to be known, the variable attenuation device being arranged axially with respect to the microwave source (22) and the electromagnetic field measuring sensor (23), between the microwave source and the electromagnetic field measuring sensor (23);
- a control cage (25), in which are provided:
• a control member (26); and
• a viewing member (27).

2. The device according to claim 1, wherein this liquid is alcohol.

3. The device according to claim 2, wherein the control member (26) comprises:
- an interface unit for controlling electromagnetic valves and alcohol pumps; and
- an interface unit for remote control.

4. The device according to claim 1, which comprises polyethylene and/or polycarbon elements.

5. The device according to any of the preceding claims, for high powers ranging from a few kilowatts to hundreds of megawatts in pulsed mode.

6. A method for measuring an electromagnetic signal for high powers ranging from a few kilowatts to hundreds of megawatts in pulsed mode, using a device according to any one of claims 1 to 5, wherein the piston (14) is displaced of a desired length to vary the variable volume filled with liquid (15).
